# EUROPEAN PATENT APPLICATION

(11) **EP 1 585 376 A1**
(43) Date of publication of application: **12.10.2005**
(21) Application number: 05250641.7
(22) Date of filing: 04.02.2005
(51) Int. Cl.: H05K 3/36, H04N 5/64

(54) **Combination system including two recording/reproducing units and a digital broadcast receiver**

(30) Priority: 08.03.2004 KR 2004015572
(71) Applicant: SAMSUNG ELECTRONICS CO., LTD., Gyeonggi-do (KR)
(72) Inventor: Kim, Eung-sun, Yeongtong-gu, Suwon-si, Gyeonggi-do (KR)
(74) Representative: Waddington, Richard

(57) **Abstract**

The present invention discloses a combination system and method, including a housing (10); a first recording/reproducing unit (20) installed inside the housing (10), for recording/reproducing data in a first recording medium; a second recording/reproducing unit (30) installed inside the housing (10), for recording/reproducing data in a second recording medium; and a digital broadcast receiving module (40) perpendicularly installed inside the housing (10), for receiving digital broadcasts externally.

## Description

The present invention relates to a combination system and method for combining two different devices into one system. More particularly, the present invention relates to a system and method for providing a combination system capable of receiving digital broadcasts.

A combination system or combo-system (or simply 'combo') typically refers to more than two different devices being combined into one integrated system. One example of the combo-system is a digital video or versatile disk player/video cassette recorder (DVDP/VCR) combo-system combining the functions of a DVDP and a VCR.

The DVDP/VCR combo-system includes an exterior housing, a DVDP unit and a VCR unit installed inside the housing. Particularly, the VCR unit includes an analog tuner for receiving an analog broadcast, which is received through an external antenna, through a cable. The analog tuner is connected to a television set (or TV) and allows a user to watch the analog broadcast.

Of late, a digital broadcasting system with high picture quality and high sound quality is preferred to the traditional analog broadcasting system. To receive a digital broadcast, a digital broadcasting receiver, such as a set-top-box, is required.

In addition, to watching satellite broadcasting, not ground-wave broadcasting, a user needs a digital broadcasting receiver mounted with a tuner for use exclusively in satellite broadcasting.

The digital broadcasting receiver is typically integrated into a TV or can be purchased as a separate product.

However, it is very inefficient to produce and sell home appliances with different functions separately in view of the cost of manufacturing and limited available installation space.

As an attempt to solve these problems, a combo-system combining more than two products into one system has been developed. In this regard, it is required to develop a combo-system including the digital broadcasting receiver as well.

Accordingly, the present invention provides a combination system combined with a digital broadcasting receiver and recording/reproducing units adopting at least two different recording media and a method thereof.

According to the present invention there is provided an apparatus and method as set forth in the appended claims. Preferred features of the invention will be apparent from the dependent claims, and the description which follows.

According to one aspect of the present invention there is provided a combination system and method, including a housing; a first recording/reproducing unit installed inside the housing, and for recording/reproducing data in a first recording medium; a second recording/reproducing unit installed inside the housing, and for recording/reproducing data in a second recording medium; and a digital broadcast receiving module perpendicularly installed inside the housing for receiving digital broadcasts from outside.

Preferably, the first and second recording/reproducing units are installed parallel to each other within the housing, and the module is disposed between the first and second recording/reproducing units.

Preferably, the combination system further includes a first board electrically connected to the first and second recording/reproducing units, respectively, and the module includes a second board installed on the first board at an upright position, and a digital tuner installed on the second board for receiving digital broadcasts from an external antenna.

Preferably, the module further includes: a connector for supporting the second board to have an upright position on the first board, and connecting the first and second boards to enable signal communication therebetween; and ground brackets attached to the first board and the second board, respectively, and for electrically connecting the first board and the second board.

Preferably, the connector and the ground brackets are inserted into the first and second boards, respectively, and are fixed thereto through soldering.

Preferably, the first recording medium is a disk and the second recording medium is a magnetic tape.

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:
FIG. 1 is a schematic diagram of a combination system according to an embodiment of the present invention;
FIG. 2 is a plan view of the combination system illustrated in FIG. 1; and
FIG. 3 is an exploded perspective view of a board module illustrated in FIG. 1.

A combination system in accordance with preferred embodiments of the present invention will now be described in detail with reference to the accompanying drawings.

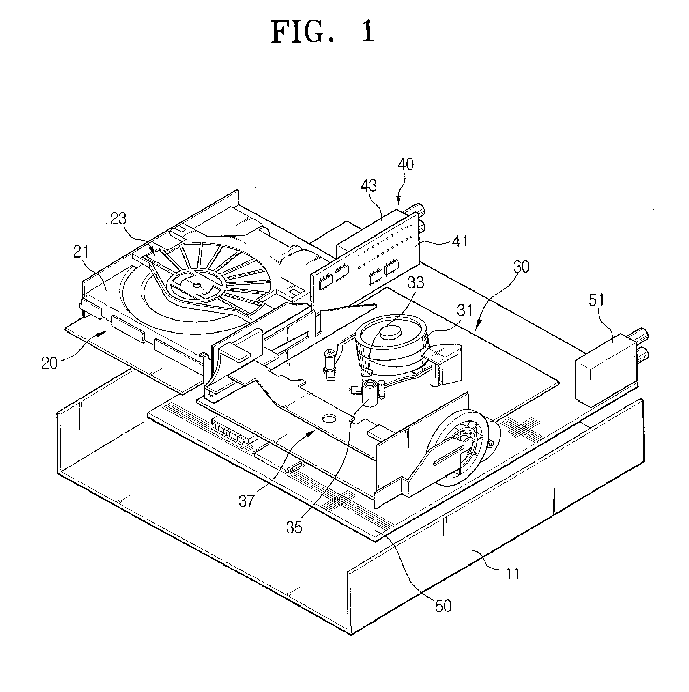

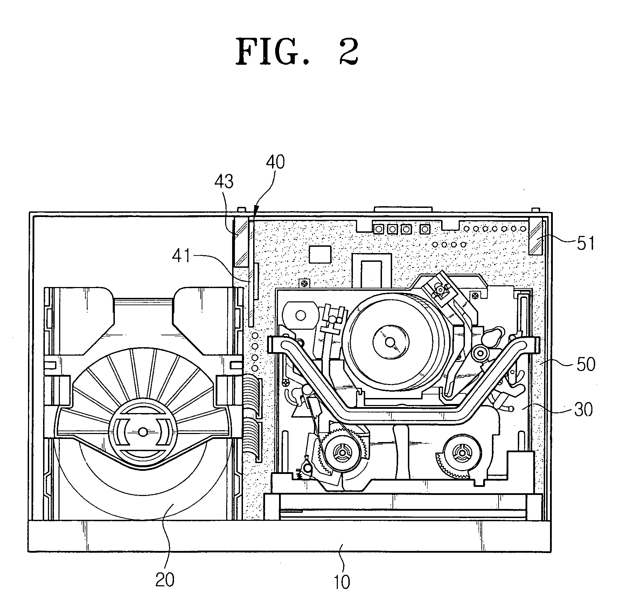

Referring to FIG. 1, the combination system according to the embodiment of the present invention includes a housing 10 (see FIG. 2), a first recording/reproducing unit 20 installed in the housing 10, a second recording/reproducing unit 30 installed inside the housing 10, and a digital broadcast receiving module 40.

The housing 10 forms the exterior of the combination system, and has a designated space inside. The housing 10 includes a lower case 11, an upper case (not shown), and a front panel (not shown).

In an embodiment of the present invention, the first recording/reproducing unit 20 will be explained in conjunction with a digital video or versatile disk player (DVDP) assembly, which records/reproduces data in a first recording medium such as a disk, for example. That is, the first recording/reproducing unit 20 includes a disk tray 21 for loading/unloading the disk in/out of the housing 10, a chucking unit 23 mounted on the disk tray for chucking the loaded disk, a driving unit (not shown) for rotating the disk loaded by the disk tray 21 at high speeds, and an optical pickup unit (not shown). Here, the driving unit includes a spindle motor and a turntable. The structures of the driving unit and the optical pickup unit are conventional so no further details will be provided.

The second recording/reproducing unit 30 records/reproduces data in a second recording medium which is different from the first recording medium. In an embodiment of the present invention, the second recording/reproducing unit 30 will be explained in conjunction with a video cassette recorder (VCR) assembly for example. Therefore, the second recording medium is a magnetic tape. And, the second recording/reproducing unit 30 is installed inside the housing 10 in parallel to the first recording/reproducing unit 20.

The structure of the VCR assembly adopted in an embodiment of the present invention for the second recording/reproducing unit 30 is similar to the prior art.

That is, the VCR assembly includes a head drum 31 installed on a deck frame 33, a tape loading/unloading unit 33 for loading/unloading a tape into/out of the head drum 31, a guide unit 35 for guiding the motion of the tape, and a cassette tape holder unit 37.

Inside the housing 10 is a first board 50. The first board 50 is used for the operation of the first and second recording/reproducing units 20, 30 and for processing signals therefrom. In short, the first board 50 is called an integration board for integrating the boards for the first and second recording/reproducing units 20, 30 into one board. As illustrated in FIG. 2, the first board 50 is installed under the second recording/reproducing unit 30, and part of the first board 50 is located under the first recording/reproducing unit 20.

An analog tuner 51 is installed on the first board 50. The analog tuner 51 selectively receives necessary analog broadcasting channel signals among broadcasting signals received from an external antenna, and transfers them at a fixed frequency required of the TV.

The digital broadcast receiving module 40 is installed inside the housing 10 at an upright position. Preferably, the module 40 is disposed between the first and second recording/reproducing units 20, 30. For example, unlike conventional DVD/VCR combo-systems, the module 40 can be installed at a more effective position within the housing 10 without enlarging the product.

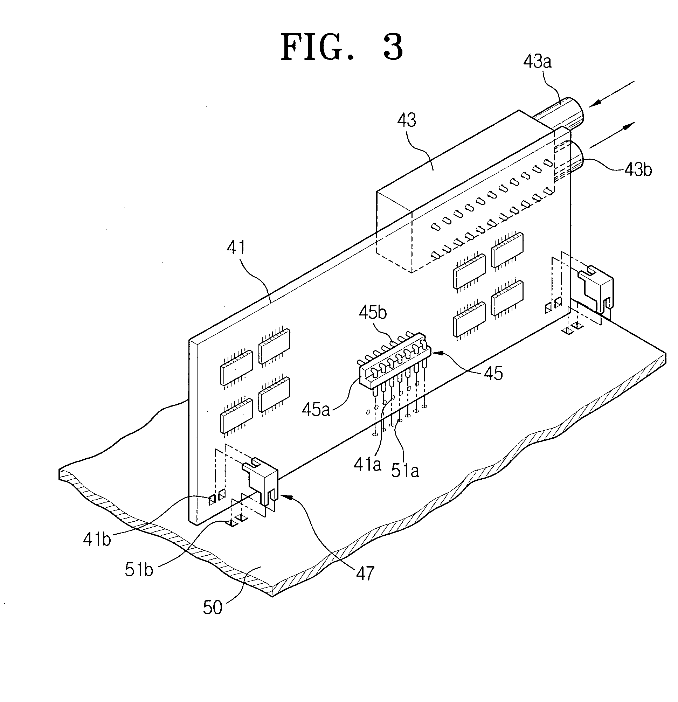

The module 40 includes a second board 41 perpendicularly installed on the first board 50, and a digital tuner 43 supported by the second board 41. Designated electronic devices are arranged on a first surface of the second board 41, and the digital tuner 43 is supported on the second surface of the second board 41. The digital tuner 43 includes an input unit 43a (see FIG. 3) for selectively receiving digital signals from the external antenna, and an output unit 43b for outputting a designated signal from the received signals. By connecting the output unit 43b to the TV set, a user can watch digital broadcasts.

Referring to FIG. 3, the module 40 further includes a connector 45 for electrically connecting the second board 41 and the first board 50, and a ground bracket 47.

The connector 45 includes a holder 45a for supporting the first and second boards 50, 41 through a direct contact, and terminal pins 45b extended from the holder 45a, each being combined with the boards 50, 41. Through these terminal pins 45b the first and second boards 50, 41 are electrically connected to each other for transferring signals. Each of the boards 50, 41 has a plurality of pin holes 51a, 41a in which the terminal pins 45b are inserted, respectively. When the terminal pins 45b are respectively inserted into the pinholes 51a, 41a, they are fixed together through soldering.

Two ground brackets 47 are installed on both sides (i.e., one ground bracket on each side), and the connecter 45 is located therebetween. The ground brackets 47 are inserted into a plurality of ground holes 51b, 41b formed on the first and second boards 50, 41, respectively. After the ground brackets 47 are inserted into the ground holes, they are fixed together through soldering.

As described above, the connector 45 and the ground brackets 47 respectively connect the first board 50 and the second board 41 electrically, and at the same time support the second board 41 to maintain an upright position on the first board 50.

Although an embodiment of the present invention illustrated the DVDP assembly as the first recording/reproducing unit 20 and the VCR assembly as the second recording/reproducing unit 30, these are only illustrative. In other words, at least two data recording/reproducing equipments among the DVDP assembly, VCR assembly, hard disk drive (HDD) assembly, and digital video disk recorder (DVDR) assembly can be combined with the digital broadcasting receiver into one combo-system.

As described above, the combination system in embodiments of the present invention has combined the first and second recording/reproducing units such as the DVDP assembly and the VCR assembly with the digital broadcasting receiver into one system. Therefore, customers are provided with a less expensive, three-function combo-product.

In particular, installing the digital broadcast receiving module inside the housing at an upright position, manufacturers do not have to expand the inside space of the housing or increase the size of the product.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A combination system, comprising:
a housing (10);
a first recording/reproducing unit (20) installed inside the housing (10) for recording/reproducing data in a first recording medium;
a second recording/reproducing unit (30) installed inside the housing (10) for recording/reproducing data in a second recording medium; and
a digital broadcast receiving module (40) perpendicularly installed inside the housing (10) for receiving digital broadcasts externally.

2. The combination system according to claim 1, wherein the first and second recording/reproducing units (20,30) are installed in parallel to each other within the housing (10), and the module (40) is disposed between the first and second recording/reproducing units (20,30).

3. The combination system according to claim 1 or claim 2, further comprises a first board (50) electrically connected to the first and second recording/reproducing units (20,30), respectively, and the module (40) comprises a second board (41) installed on the first board (50) at an upright position, and a digital tuner (43) installed on the second board (41) for receiving digital broadcasts from an external antenna.

4. The combination system according to claim 3, wherein the module (40) further comprises:
a connector (45) for supporting the second board (41) in an upright position on the first board (50), and connecting the first and second boards (50,41) to enable signal communication therebetween; and
ground brackets (47) attached to the first board (50) and the second board (41), respectively, for electrically connecting the first board (50) and the second board (41).

5. The combination system according to claim 4, wherein the connector (45) and the ground brackets (47) are inserted into the first and second boards (50,41), respectively, and are fixed thereto through soldering.

6. The combination system according to any preceding claim, wherein the first recording medium comprises a disk and the second recording medium comprises a magnetic tape.

7. The combination system according to any preceding claim, wherein the module (40) is perpendicularly installed inside the housing.

8. A method of providing a combination system, comprising:
providing a housing (10);
providing a first recording/reproducing unit (20) inside the housing (10) for recording/reproducing data in a first recording medium;
providing a second recording/reproducing unit (30) inside the housing (10) for recording/reproducing data in a second recording medium; and
installing a digital broadcast receiving module (40) perpendicularly inside the housing (10) for receiving digital broadcasts externally.

9. The method according to claim 8, wherein the first and second recording/reproducing units (20,30) are installed in parallel to each other within the housing (10), and the module (40) is disposed between the first and second recording/reproducing units (20,30).

10. The method according to claim 8 or claim 9 further
comprising:
electrically connecting a first board (50) to the first and second recording/reproducing units (20,30), respectively;
installing a second board (41) installed on the first board (50) at an upright position in the module (40);
installing a digital tuner (43) on the second board (41) for receiving digital broadcasts from an external antenna.

11. The method according to claim 10, wherein the module (40) further comprises:
supporting the second board (41) in an upright position on the first board (50) via a connector (45);
connecting the first and second boards (50, 41) to enable signal communication therebetween; and electrically connecting the first board (50) and the second board (41) via ground brackets (47) attached to the first board (50) and the second board (41), respectively.

12. The method according to claim 11, further comprising:
inserting the connector (45) and the ground brackets (47) into the first and second boards (50,41) respectively, and are fixed thereto through soldering.

13. The method according to any one of claims 8 to 12, wherein the first recording medium comprises a disk and the second recording medium comprises a magnetic tape.

14. The method according to any one of claims 8 to 13, further comprising:
installing the module (40) perpendicularly inside the housing (10).
